(19) Europäisches Patentamt

European Patent Office

Office européen des brevets

(11) **EP 0 681 235 B1**

(12) **EUROPÄISCHE PATENTSCHRIFT**

(45) Veröffentlichungstag und Bekanntmachung des Hinweises auf die Patenterteilung:
**05.12.2001 Patentblatt 2001/49**

(51) Int Cl.$^7$: **G06F 7/60**, G01R 21/127, G06G 7/161, G06J 1/02, G01R 21/133

(21) Anmeldenummer: **95106093.8**

(22) Anmeldetag: **24.04.1995**

(54) **Anordnung zum Summieren von Produkten zweier gleichen oder unterschiedlichen Signale**

Device for summing up products of two equal or different signals

Dispositif pour l'addition de produits de deux signaux égaux ou différents

(84) Benannte Vertragsstaaten:
**AT CH DE FR GB LI**

(30) Priorität: **05.05.1994 CH 141194**

(43) Veröffentlichungstag der Anmeldung:
**08.11.1995 Patentblatt 1995/45**

(73) Patentinhaber: **Siemens Metering AG**
**6300 Zug (CH)**

(72) Erfinder:
 • **Gruber, Peter**
  **CH-8909 Zwillikon (CH)**
 • **Cermeno, Raul**
  **CH-6330 Cham (CH)**
 • **Lienhard, Heinz**
  **Ch-6300 Zug (CH)**

(74) Vertreter: **Zedlitz, Peter, Dipl.-Inf. et al**
 **Patentanwalt,**
 **Postfach 22 13 17**
 **80503 München (DE)**

(56) Entgegenhaltungen:
 **GB-A- 2 167 619**

 • **IEEE JOURNAL OF SOLID-STATE CIRCUITS, Bd. 26, Nr. 12, Dezember 1991 NEW YORK US, Seiten 2008-2015, XP 000272862 S. GARVERICK 'A Programmable Mixed-Signal ASIC for Power Metering'**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf eine Anordnung zum Summieren von Produkten zweier gleichen oder unterschiedlichen Signale gemäss dem Oberbegriff des Anspruchs 1.

Die Anordnung wird verwendet, z. B. in Elektrizitätszählern, zum Ermitteln von Strom- und/oder Spannungs-Effektivwerten, Korrelationen, gemittelten elektrischen Leistungen und/oder Energiewerten. Die letzteren sind bekanntlich gleich einer Summe momentaner Leistungswerte, die ihrerseits jeweils gleich einem Produkt eines momentanen Spannungswertes und eines zugehörigen momentanen Stromwertes sind.

Bekannt ist eine klassische Multiplikation, in der in einer langsamem Taktfrequenz zwei Operanden von je R Bits miteinander multipliziert werden, die z. B. zuerst vorher durch Filterung in einer schnelleren Taktfrequenz mit anschliessender Dezimation gewonnen wurden.

In der GB 2 167 619 ist eine Anordnung zum Summieren von Produkten zweier Signale beschrieben Dabei wird mindestens eines der Signale auf einen Signaleingang eines mit einer ersten Taktfrequenz betriebenen Sigma-Delta-Modulators geführt, dessen Ausgang mit einem von zwei Signaleingängen eines Multiplizier-Gliedes verbunden ist.

Der Erfindung liegt die Aufgabe zugrunde, unter mindestens annähernder Beibehaltung der mit der klassischen Multiplikation erreichbaren Genauigkeit, eine Anordnung der eingangs genannten Art zu realisieren, welche keine Multiplikation zweier R-Bit Operanden, sondern nur einfache Verschiebe- und algebraische Additions-Operationen in der schnelleren Taktfrequenz erfordern, wobei z. B. eine Berechnung eines Effektivwertes eines Stromes in einem Dynamikbereich von 1:1000 mit einer Genauigkeit von 0.5% ohne grossen Aufwand möglich ist. Die erfindungsgemässe Anordnung ist besonders vorteilhaft, wenn die Multiplikationen auf einem speziellen Halbleiter-Chip realisiert werden sollen.

Die genannte Aufgabe wird erfindungsgemäss durch die im Kennzeichen des Anspruchs 1 angegebenen Merkmale gelöst. Vorteilhafte Ausgestaltungen der Erfindung ergeben sich aus den abhängigen Ansprüchen.

Ausführungsbeispiele der Erfindung sind in der Zeichnung dargestellt und werden im folgenden näher beschrieben.

Es zeigen:

Fig. 1     ein Blockschaltbild einer ersten Variante einer Anordnung,
Fig. 2     ein Blockschaltbild einer zweiten Variante der Anordnung,
Fig. 3     ein Blockschaltbild einer dritten Variante der Anordnung,
Fig. 4     ein Blockschaltbild eines bekannten Sigma-Delta-Modulators zweiter Ordnung und
Fig. 5     ein Blockschaltbild eines erfindungsgemässen Multiplizier/Addier-Gliedes.

In den erfindungsgemässen Anordnungen wird jeweils ein erstes Signal $u[t]$ bzw. $i[t]$ mit einem zweiten gleichen oder unterschiedlichen Signal $u[t]$ oder $i[t]$ oder $f[t]$ multipliziert. Dabei ist mindestens eines der Signale $u[t]$ bzw. $i[t]$ auf einen Signaleingang eines mit einer ersten Taktfrequenz $1/T_S$ betriebenen Sigma-Delta-Modulators 1 bzw. 2 geführt, dessen Ausgang mit mindestens einem von zwei Signaleingängen eines Multiplizier/Addier-Gliedes 3 verbunden ist. Das Signal $u[t]$ ist z. B. eine elektrische Spannung, während das Signal $i[t]$ vorzugsweise eine elektrische Spannung darstellt, die proportional einem elektrischen Strom ist Gehört letzterer zur Spannung $u[t]$, dann ist das Produkt beider Signale $u[t]$ und $i[t]$ proportional der zugehörigen Momentanleistung $p[t] = u[t].i[t]$.

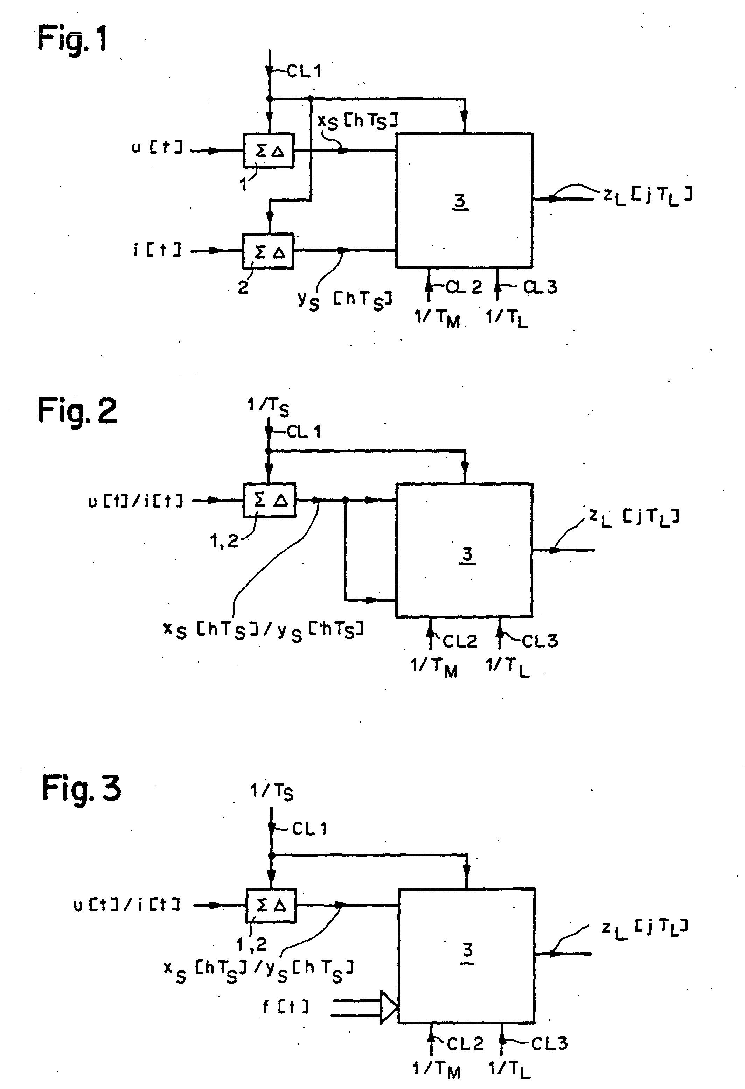

In der in der Fig. 1 dargestellten ersten Variante der Anordnung sind die beiden Signale unterschiedliche zeitfunktionale Signale $u[t]$ und $i[t]$, die auf einen Signaleingang je eines zugehörigen, mit der ersten Taktfrequenz $1/T_S$ betriebenen Sigma-Delta-Modulators 1 bzw. 2 geführt sind. Die Ausgänge der beiden Sigma-Delta-Modulatoren 1 und 2 sind dabei mit je einem der beiden Signaleingänge des Multiplizier/Addier-Gliedes 3 verbunden. Das zeitfunktionale Signal $u[t]$ ist somit über den Sigma-Delta-Modulator 1 auf einen ersten der beiden Signaleingänge und das zeitfunktionale Signal $i[t]$ über den Sigma-Delta-Modulator 2 auf einen zweiten der beiden Signaleingänge des Multiplizier/Addier-Gliedes 3 geführt.

In der in der Fig. 2 dargestellten zweiten Variante der Anordnung sind die beiden Signale gleiche zeitfunktionale Signale $u[t]$ und $u[t]$ bzw. $i[t]$ und $i[t]$, wovon eines auf den Signaleingang des Sigma-Delta-Modulators 1 bzw. 2 geführt ist. Der Ausgang des letzteren ist mit den beiden Signaleingängen des Multiplizier/Addier-Gliedes 3 verbunden. Die beiden gleichen zeitfunktionalen Signale $u[t]$ und $u[t]$ bzw. $i[t]$ und $i[t]$ werden in der erfindungsgemässen Anordnung so miteinander multipliziert, däss das Quadrat $u^2[t]$ bzw. $i^2[t]$ des betreffenden zeitfunktionalen Signals $u[t]$ bzw. $i[t]$ erzeugt wird.

In der in der Fig. 3 dargestellten dritten Variante der Anordnung ist das erste Signal-ein im voraus nicht bekanntes zeitfunktionales Signal $u[t]$ bzw. $i[t]$ und das zweite Signal eine im voraus bekannte zeitvariable Funktion $f[t]$. Das erste Signal $u[t]$ bzw. $i[t]$ ist dabei auf den Signaleingang des zugehörigen Sigma-Delta-Modulators 1 bzw. 2 geführt. Der Ausgang des letzteren ist mit einem der beiden Signaleingänge des Multiplizier/Addier-Gliedes 3 verbunden. Einbit- oder Mehrbit-Digitalwerte der bekannten zeitvariablen Funktion f[t] sind ihrerseits auf den anderen der beiden Signaleingänge des Multiplizier/Addier-Gliedes 3 geführt. Die Werte der bekannten zeitvariablen Funktion f[t] stehen nicht immer in Gestalt eines 1-Bit Stromes zur Verfügung und werden dann über eine Busverbindung als Mehrbit-Digitalwerte dem betreffenden Signaleingang des Multiplizier/Addier-Gliedes 3 zugeführt, der dann als Bus-Eingang ausgebildet ist. In der Fig. 3 wird das Signal u[t] bzw. i[t] über den Sigma-Delta-Modulator 1 bzw. 2 als 1-Bit Strom dem ersten Signaleingang des Multiplizier/Addier-Gliedes 3 zugeführt, während z. B. Mehrbit-Digitalwerte der Funktion f[t] dem zweiten Signaleingang zugeführt sind. In der dritten Variante dient die Multiplikation/Addition z. B. der Ermittlung von Korrelationen.

Das Multiplizier/Addier-Glied 3 ist in allen Varianten über getrennte Takteingänge mit drei Taktsignalen CL1, CL2 und CL3 gespeist. Die Sigma-Delta-Modulatoren 1 und 2 sind jeweils mit dem Taktsignal CL1 gespeist, dessen Frequenz die erste Taktfrequenz $1/T_S$ ist. Die zeitfunktionalen Signale u[t] und i[t] werden im zugehörigen Sigma-Delta-Modulator 1 bzw. 2 mit der ersten Taktfrequenz $1/T_S$ abgetastet. Die Frequenz von CL2 ist die zweite Taktfrequenz $1/T_M$ und diejenige von CL3 die dritte Taktfrequenz $1/T_L$. Es gilt $T_S < T_M < T_L$, mit $T_M = N.T_S$ und $T_L = W.T_M$. Die erste Taktfreqüenz $1/T_S$ ist somit grösser als die zweite Taktfrequenz $1/T_M$ und die letztere ihrerseits grösser als die dritte Taktfrequenz $1/T_L$. Die beiden als ganzzahlig angenommenen Verhältnisse $N = T_M/T_S$ und $W = T_L/T_M$ werden als Überabtastraten oder Oversamplingfaktoren ("Oversampling ratio") bezeichnet und stellen daher eine erste bzw. zweite Überabtastrate dar.

Nachfolgend bezeichnen $hT_S$, $kT_M$ und $jT_L$ die zu der Taktfrequenz $1/T_S$ bzw. $1/T_M$ bzw. $1/T_L$ gehörigen Abtastzeitpunkte, wobei h, k und j laufende Abtastnummern n = 0, 1, 2, 3, ..., usw. darstellen. Signale der Taktfrequenz $1/T_S$ besitzen nachfolgend einen Index S, Signale der Taktfrequenz $1/T_M$ einen Index M und ein Signal der Taktfrequenz $1/T_L$ einen Index L. Dementsprechend sind die Ausgangssignale der Sigma-Delta-Modulatoren 1 und 2 mit $x_S[hT_S]$ bzw. $y_S[hT_S]$ und das Ausgangssignal des Multiplizier/Addier-Gliedes 3 mit $z_L[jT_L]$ bezeichnet (Siehe Fig. 1 bis Fig. 3).

Der Aufbau und die Arbeitsweise der Sigma-Delta-Modulatoren 1 und 2 sind aus der Druckschrift tm, Technisches Messen 59 (1992) Hefte 1, 2, 6 und 7/8, Seiten 262 bis 268, Anwendung von Oversampling-Verfahren zur Erhöhung der Auflösung digital erfasster Signale, M. Barmettler und P. Gruber, R. Oldenbourg Verlag, bekannt, welche nachfolgend als Barmettler et al bezeichnet wird.

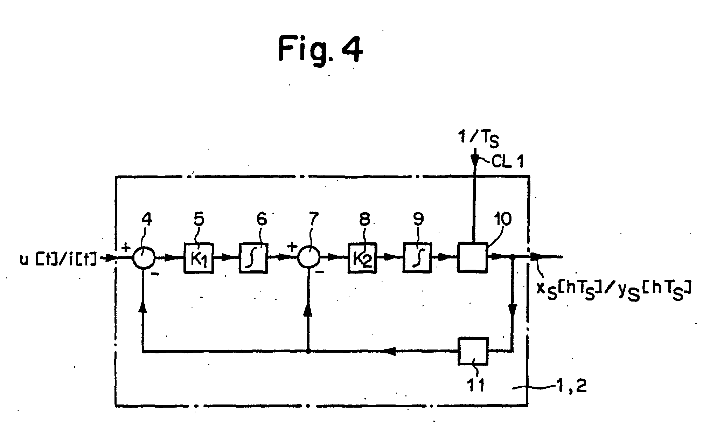

Jeder Sigma-Delta-Modulator 1 bzw. 2 der drei Varianten ist vorzugsweise ein Sigma-Delta-Modulator zweiter Ordnung. In der Fig. 4 ist ein solcher, an sich bekannter Sigma-Delta-Modulator 1 bzw. 2 zweiter Ordnung dargestellt, dessen Vorwärtspfad in der angegebenen Reihenfolge aus einer Reihenschaltung eines ersten Differenzbildungs-Gliedes 4, eines ersten Verstärkungsgliedes 5, eines ersten Integrators 6, eines zweiten Differenzbildungs-Gliedes 7, eines zweiten Verstärkungsgliedes 8, eines zweiten Integrators 9 und eines 1-Bit Analog/Digital-Wandlers 10 besteht, wobei letzterer vorzugsweise ein getasteter Komparator ist und bei den beiden Differenzbildungs-Gliedem 4 und 7 für die Reihenschaltung jeweils der Plus-Eingang verwendet wird. Der Ausgang des 1-Bit Analog/Digital-Wandlers 10, der gleichzeitig der Ausgang des Sigma-Delta-Modulators 1 bzw. 2 ist, ist über einen 1-Bit Digital/Analog-Wandler 11, z. B. ein Halteglied nullter Ordnung ("Zero order hold" ZOH) mit den Minus-Eingängen der beiden Differenzbildungs-Glieder 4 und 7 verbunden. Ein Takteingang des 1-Bit Analog/Digital-Wandlers 10 wird vom Taktsignal CL1 mit der ersten Taktfrequenz $1/T_S$ gespeist. In den Verstärkungsgliedem 5 und 8 werden deren Eingangssignale mit einem Faktor $K_1$ bzw. $K_2$ gewichtet.

Für das Ausgangssignal $x_S[hT_S]$ des Sigma-Delta Modulators 1 gilt:

$$x_S[hT_S] = u_S[hT_S] + \Delta_{Su}[hT_S] \tag{1},$$

mit

$$|u_S[hT_S]| < Q/2 \tag{2}$$

Für das Ausgangssignal $y_S[hT_S]$ des Sigma-Delta Modulators 2 gilt:

$$y_S[hT_S] = i_S[hT_S] + \Delta_{Si}[hT_S] \tag{1a},$$

mit

$$|i_S[hT_S]| < Q/2 \tag{2a}$$

Dabei ist Q die Höhe der Quantisierungsstufe des 1-Bit Analog/Digital-Wandlers 10. Die Signale $u_S[hT_S]$ und $i_S[hT_S]$ sind in erster Näherung bis auf eine Verzögerung um einen oder zwei Takte die nichtquantisierten, mit der Taktfrequenz $1/T_S$ abgetasteten Signale u[t] bzw. i[t]. Die Signale $\Delta_{Su}[hT_S]$ und $\Delta_{Si}[hT_S]$ sind durch die Quantisierung verursachte Fehlersequenzen am Ausgang des Sigma-Delta Modulators 1 bzw. 2, von denen bekannt ist, dass sie je einen differenzierenden Charakter aufweisen. Die Ungleichungen (2) und (2a) geben jeweils den Geltungsbereich des Eingangssignals u[t] bzw. i[t] an. Wird das letztere auf $\pm 1$ begrenzt, folgt daraus Q = 2. Die zeitfunktionalen Signale u[t] und i[t] werden im Sigma-Delta-Modulator 1 bzw. 2 in je einen 1-Bit- Strom $x_S[hT_S]$ bzw. $y_S[hT_S]$ der Taktfrequenz $1/T_S$ umgewandelt, der ein zweiwertiges Signal {+Q/2, -Q/2} oder z. B. {+1, -1} darstellt, welches nur aus den beiden Werten +Q/2 und -Q/2 bzw. +1 und -1 besteht. Das Ausgangssignal $x_S[hT_S]$ bzw. $y_S[hT_S]$ des Sigma-Delta-Modulators 1 bzw. 2 ist somit eine Folge von zweiwertigen Impulsen.

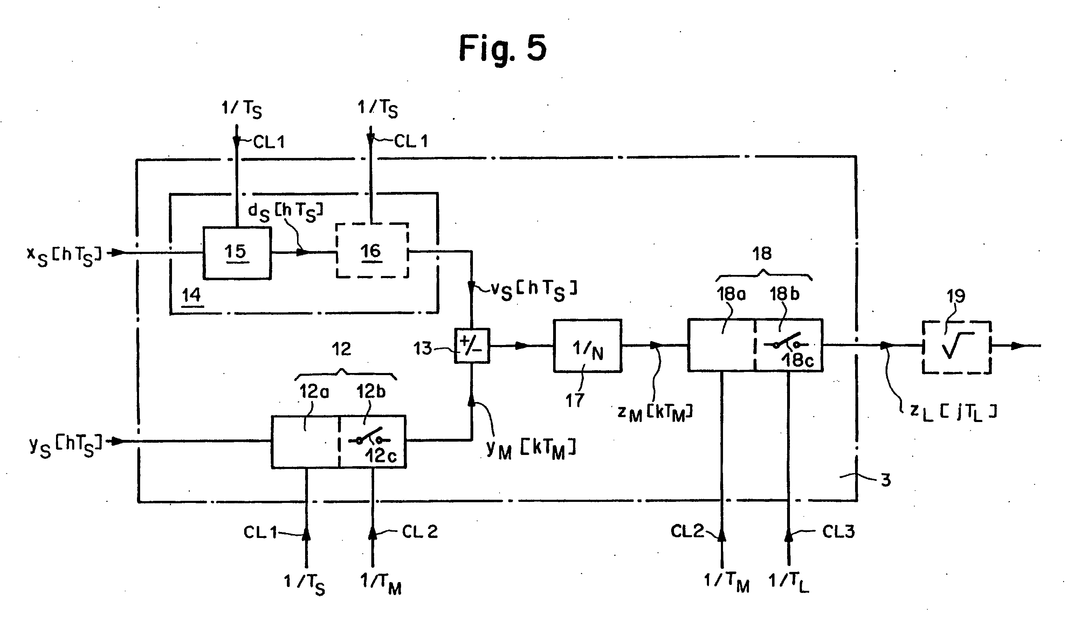

Wie in der Fig. 5 dargestellt ist innerhalb des Multiplizier/Addier-Gliedes 3 der eine, z. B. zweite Signaleingang über ein mit der ersten Taktfrequenz $1/T_S$ betriebenes erstes Dezimationsfilter 12 auf einen ersten Eingang eines Additionsgliedes 13 und der andere, z. B. erste Signaleingang über eine mit der ersten Taktfrequenz $1/T_S$ betriebene Verzögerungsanordnung 14 auf einen zweiten Eingang des Additionsgliedes 13 geführt. Bei der Multiplikation der Spannung u[t] mit dem zugehörigen Strom i[t] zwecks Ermittlung der Summe entsprechender Momentanleistungen (Siehe Fig. 1) wird das Signal i[t], welches in der Regel einen grösseren Dynamikbereich besitzt als die Spannung u[t], vorzugsweise dem zweiten Signaleingang des Multiplizier/Addier-Gliedes 3 und damit dem Dezimationsfilter 12 zugeführt, während die Spannung u[t] vorzugsweise dem ersten Signaleingang, d. h. der Verzögerungsanordnung 14 zugeführt wird. Die Genauigkeit ist dabei besser als diejenige bei der Ermittlung der Effektivwerte des Stromes i[t] (Siehe Fig. 2), da die grosse Dynamik nur bei einem Operanden, nämlich dem Strom i[t] vorhanden ist. In der dritten Variante (Siehe Fig. 3) wird das Signal u[t] bzw. i[t] vorzugsweise dem ersten Signaleingang des Multiplizier/Addier-Gliedes 3 und damit der Verzögerungsanordnung 14 zugeführt, während die z. B. Mehrbit-Digitalwerte der Funktion f[t] vorzugsweise dem zweiten Signaleingang und damit dem Dezimationsfilter 12 zugeführt werden.

Das Additionsglied 13 dient der Realisation algebraischer Additionen und sein Ausgang ist über ein Dividierglied 17 auf einen Signaleingang eines mit der zweiten Taktfrequenz $1/T_M$ betriebenen zweiten Dezimationsfilters 18 geführt, dessen Ausgang einen Ausgang des Multiplizier/Addier-Gliedes 3 bildet. Der Teilungsfaktor des Dividiergliedes 17 ist gleich dem Verhältnis $T_M/T_S$ der schnellen ersten Taktfrequenz $1/T_S$ des Taktsignals CL1 zur mittelschnellen zweiten Taktfrequenz $1/T_M$ des Taktsignals CL2, d. h. gleich der ersten Überabtastrate N.

Die Dezimationsfilter 12 und 18 sind definitionsgemäss Digitalfilter, deren Ausgangssignal mit einer niedrigeren Taktfrequenz ausgelesen wird als mit welcher ihr Eingangssignal im eigentlichen Digitalfilter verarbeitet wird. Dies ist in der Fig. 5 symbolisch angedeutet, indem dort die Dezimationsfilter 12 und 18 jeweils durch einen Eingangs-Funktionsblock 12a bzw. 18a und einen nachgeschalteten Ausgangs-Funktionsblock 12b bzw. 18b dargestellt sind. Die Eingangs-Funktionsblöcke 12a und 18a stellen jeweils das eigentliche Digitalfilter dar, während die Ausgangs-Funktionsblöcke 12b und 18b den Auslesevorgang andeuten, der jeweils durch einen Lese-Schaltkontakt 12c bzw. 18c symbolisch dargestellt ist. Der Eingangs-Funktionsblock 12a besitzt einen Takteingang, der vom Taktsignal CL1 mit der schnellen ersten Taktfrequenz $1/T_S$ gespeist ist, während der Ausgangs-Funktionsblock 12b einen Takteingang aufweist, der vom Taktsignal CL2 mit einer langsameren, nämlich der mittelschnellen zweiten Taktfrequenz $1/T_M$ gespeist ist. Der Eingangs-Funktionsblock 18a besitzt einen Takteingang, der vom Taktsignal CL2 mit der mittelschnellen zweiten Taktfrequenz $1/T_M$ gespeist ist, während der Ausgangs-Funktionsblock 18b einen Takteingang aufweist, der vom Taktsignal CL3 mit der langsamen dritten Taktfrequenz $1/T_L$ gespeist ist. Die Ausgangs-Funktionsblöcke 12b und 18b der Dezimationsfilter 12 und 18 werden somit mit einer niedrigeren Taktfrequenz $1/T_M$ bzw. $1/T_L$ betrieben als der zugehörige Eingangs-Funktionsblock 12a bzw. 18a, welcher mit der Taktfrequenz $1/T_S$ bzw. $1/T_M$ betrieben wird, wobei die zweite Taktfrequenz $1/T_M$ und die dritte Taktfrequenz $1/T_L$ jeweils dem Lesen des Ausgangssignals des ersten bzw. zweiten Dezimationsfilters 12 bzw. 18 dienen.

Das Dezimationsfilter 12 ist vorzugsweise ein Sinc-Filter der Ordnung K und der Länge N, d. h. seine Länge ist vorzugsweise gleich der ersten Überabtastrate N, also gleich dem Verhältnis $T_M/T_S$ der schnellen ersten Taktfrequenz $1/T_S$ zur mittelschnellen zweiten Taktfrequenz $1/T_M$. Es gelten z. B. K = 3 und N = 128. Das Dezimationsfilter 18 ist vorzugsweise ein Sinc-Filter erster Ordnung der Länge W, d. h. seine Länge ist vorzugsweise gleich der zweiten Überabtastrate W, also gleich dem Verhältnis $T_L/T_M$ der mittelschnellen zweiten Taktfrequenz $1/T_M$ zur langsamen dritten Taktfrequenz $1/T_L$.

Ein mit der Taktfrequenz $1/T_S$ betriebenes Sinc-Filter der Ordnung K und der Länge N hat bekanntlich einen Frequenzgang

$$F(e^{j\omega T_s}) = (1/N)^K (1-e^{-j\omega N T_s})^K / (1-e^{-j\omega T_s})^K = (1/N)^K [\sin(\omega N T_s / 2)/\sin(\omega T_s / 2)]^K . e^{-j\omega T_s K(N-1)/2}$$

und ein solches Filter erster Ordnung ist vorzugsweise ein Mittelwertbildner, der z. B. aus einem N-stufigen Schieberegister besteht, dessen Eingang und dessen N Parallelausgänge auf je einen von N+1 Eingängen eines gemeinsamen Addiergliedes geführt sind, wobei der Ausgang des letzteren über ein Dividierglied, dessen Teilungsfaktor N ist, auf den Ausgang des Mittelwertbildners und damit auch auf den Ausgang des Sinc-Filters geführt ist.

Die Verzögerungsanordnung 14 besteht entweder aus einem mit der ersten Taktfrequenz $1/T_S$ betriebenen Verzögerungsglied 15 oder aus einer Reihenschaltung 15;16 des mit der ersten Taktfrequenz $1/T_S$ betriebenen Verzögerungsgliedes 15 und eines nachgeschalteten, ebenfalls mit der ersten Taktfrequenz $1/T_S$ betriebenen dezimationslosen Digitalfilters 16. Je ein Takteingang des Verzögerungsgliedes 15 und, falls vorhanden, des Digitalfilters 16 wird vom Taktsignal CL1 mit der schnellen Taktfrequenz $1/T_S$ gespeist. Das nur fakultative Vorhandensein des Digitalfilters 16 ist in der Fig. 5 symbolisch angedeutet durch seine gestrichelte Darstellung. Das dezimationslose Digitalfilter 16 ("sliding filter") ist vorzugsweise ein Sinc-Filter erster Ordnung der Länge vier.

Das schnell getaktete Signal $x_S[hT_S]$ wird im Verzögerungsglied 15 um eine Verzögerungsdauer D verzögert, so dass an dessen Ausgang ein schnell getaktetes verzögertes Signal $d_S[hT_S]$ erscheint. Die Verzögerungsdauer D des Verzögerungsgliedes 15 ist vorzugsweise gleich K(N-1)/2. Wenn ein Digitalfilter 16 vorhanden ist, wird das schnell getaktete verzögerte Signal $d_S[hT_S]$ ausserdem noch durch Tiefpassfilterung im Digitalfilter 16 in ein tiefpassgefiltertes verzögertes Signal $v_S[hT_S]$ umgewandelt, wodurch ein gegenüber der schnellen Taktfrequenz $1/T_s$ tieffrequentes Nutzsignal herausgefiltert und das Quantisierungsrauschen teilweise unterdrückt wird.

Im Dezimationsfilter 12 wird der 1-Bit-Strom $y_S[hT_S]$ der schnellen Taktfrequenz $1/T_S$ tiefpassgefiltert und auf die langsamere mittelschnelle Taktfrequenz $1/T_M = 1/(N.T_S)$ dezimiert. Durch Tiefpassfilterung des schnell getakteten Signals $y_S[hT_S]$ im Dezimationsfilter 12 kann ebenfalls ein gegenüber der schnellen Taktfrequenz $1/T_s$ tieffrequentes Nutzsignal herausgefiltert und das Quantisierungsrauschen teilweise unterdrückt werden. Mit der mittelschnellen Taktfrequenz $1/T_M$ erhält man am Ausgang des Dezimationsfilters 12 ein tiefpassgefiltertes Signal $y_M[kT_M]$, welches eine viel bessere Genauigkeit besitzt als das ursprüngliche Signal, da durch eine geschickte Wahl der Taktfrequenzen $1/T_S$ und $1/T_M$ sowie der Filtercharakteristik sich eine sehr hohe Genauigkeit erreichen lässt. Die Werte von $y_M[kT_M]$ sind z. B. mittels 16 Bits dargestellt.

Je grösser die erste Überabtastrate N gewählt wird, desto stärker ist die Unterdrückung des Quantisierungseinflusses und desto grösser ist auch die Genauigkeit des gewandelten Signals. Wird der Quantisierungsfehler des 1-Bit Analog/Digital-Wandlers 10 als idealisiertes, im Intervall [-Q/2, Q/2] gleichverteiltes Rauschen betrachtet, so ist dessen Varianz

$$\sigma_\Delta^2 = \frac{Q^2}{12} \tag{3}$$

Für die linearisierte Übertragung des Quantisierungsfehlers ist die Störübertragungsfunktion des Sigma-Delta-Modulators zweiter Ordnung gleich:

$$G_\Delta(z) = (1 - z^{-1})^2 \tag{4}$$

Die Varianz des Quantisierungsfehlers am Ausgang des Sigma-Delta-Modulators 2 ist:

$$\sigma^2{}_{\Delta_s} = (T_S / 2\pi) \int_{-\pi/T_s}^{\pi/T_s} \left| G_\Delta(e^{j\omega T_s}) \right|^2 d\omega . \sigma_\Delta^2$$

$$= (T_S / 2\pi) \int_{-\pi/T_s}^{\pi/T_s} \sin^4(\omega T_s / 2) . d\omega . \sigma_\Delta^2$$

Am Ausgang des Dezimationsfilters 12 ist das Signal

$$y_M[kT_M] = i_M[kT_M] + \Delta_{Mi}[kT_M] \tag{5}$$

vorhanden. Im Falle eines konstanten Signals i[t] ist $i_M[kT_M]$ gerade gleich i[t]. Im Falle eines tieffrequenten Signals i[t] wird dagegen das dezimierte Signal $i_M[kT_M]$ durch die Tiefpasscharakteristik des Dezimationsfilters 12 etwas verzerrt, d. h. linear phasenverschoben und leicht gedämpft. Die Übertragungsfunktion des Dezimationsfilters 12 der Ordnung K und der Länge N kann sowohl rekursiv als auch nicht rekursiv sein:

$$G_N^K(z) = (1/N)^K \sum_{k_1+k_2+..+k_N=K} \binom{K}{k_1, k_2, .., k_N}(1^{k_1} z^{-k_2} z^{-2k_3} ... z^{-(N-1)k_N})$$

$$= (1/N)^K \left(\frac{1-z^{-N}}{1-z^{-1}}\right)^K \qquad\qquad (6a, 6b)$$

Zu beachten ist, dass $z^{-1}$ die Verzögerung im schnellen Takt $1/T_S$ ist. Für N = 4 gilt z.B.:

$$G_4^1(z) = (1/4)\{1+z^{-1} + z^{-2} + z^{-3}\}$$

$$G_4^2(z) = (1/4)^2\{1+2z^{-1} + 3z^{-2} + 4z^{-3} + 3z^{-4} + 2z^{-5} + z^{-6}\}$$

$$G_4^3(z)=(1/4)^3\{1+3z^{-1}+6z^{-2}+10z^{-3}+12z^{-4}+12z^{-5}+10z^{-6}+6z^{-7}+3z^{-8}+z^{-9}\} \qquad (8a,b,c)$$

Die Differenzengleichungen für K = 1, K = 2 und K = 3 ergeben jeweils:

$$y_M[kT_M] = (1/4)\{y_s[kNT_s]+y_s[(kN\text{-}1)T_s]+y_s[(kN\text{-}2)T_s]+y_s[(kN\text{-}3)T_s]\}$$

$$y_M[kT_M]=(1/4)^2\{y_s[kNT_s]+2y_s[kN\text{-}1)T_s]+3y_s[(kN\text{-}2)T_s]+4y_s[(kN\text{-}3)T_s]+$$

$$3y_s[(kN\text{-}4)T_s]+2y_s[(kN\text{-}5)T_s]+y_s[(kN\text{-}6)T_s]\}$$

$$y_M[kT_M]=(1/4)^3\{y_s[kNT_s]+3y_s[(kN\text{-}1)T_s]+6y_s[(kN\text{-}2)T_s]+10y_s[(kN\text{-}3)T_s]+$$

$$12y_s[(kN\text{-}4)T_s]+12y_s[(kN\text{-}5)T_s]+10y_s[(kN\text{-}6)T_s]+6y_s[(kN\text{-}7)T_s]+$$

$$3y_s[(kN\text{-}8)T_s]+y_s[(kN\text{-}9)T_s]\} \qquad (9a,b,c)$$

Für die Verzögerung $\tilde{z}^{-1}$ in der langsameren mittelschnellen Taktfrequenz $1/T_M$ gilt:

$$\tilde{z}^{-1} = z^{-N}$$

Drei Dinge sind von Interesse:

1) Die Summe aller Gewichte von $G_N^K(z)$ ist immer gleich 1, d.h. die Gleichstrom-Verstärkung ist gleich 1.

2) Das Gedächtnis des Dezimationsfilters 12 ist abhängig von dessen Ordnung K. Nur im Falle von K = ist das Gedächtnis gleich N-1, was bedeutet, dass in diesem Fall das Gedächtnis gerade über die Länge eines langsamen Abtastintervalls reicht. Für K > 1 gilt allgemein:

$$N_K=K(N\text{-}1)$$

Das heisst, dass in diesem Fall das Gedächtnis länger als die Dezimationsrate ist. Gleichzeitg ist auch ersichtlich, dass die Verzögerung $\tau=K(N\text{-}1)/2$ beträgt.

3) Die Gewichte haben eine spezielle Struktur, nämlich für

K = 1: rechtecksförmig,
K = 2: dreiecksförmig und
K = 3: parabolförmig mit einem abgeflachten Mittelstück.

Das die mittelschnelle Taktfrequenz $1/T_M$ aufweisende Signal $y_M[kT_M]$ hat einen Quantisierungsfehler $\Delta_{Mi}[kT_M]$, der sich aus der Reihenschaltung des Sigma-Delta-Modulators 2 und des Dezimationsfilters 12 ergibt (Siehe Barmettler et al). Für interessante Werte von N und K ergibt sich folgender Gewinn $R_i$ an Bits gegenüber dem nichtdezimierten Fall:

Für N = 128, K = 2 --> $R_i$=12.7Bits,
für N = 128, K = 3 --> $R_i$=15 Bits,
für N = 256, K = 2 --> $R_i$=14.7Bits und
für N = 256, K = 3 --> $R_i$=17.5Bits.

Das heisst, dass die statistisch ermittelten, als gleichverteilt angenommenen Fehleramplituden am Ausgang des Dezimationsfilters 12 um den Faktor $2^{R_i}$ kleiner sind.

$$|\Delta_{Mi}| \leq 2^{-R_i} Q/2 \tag{13}$$

Beispiel: Bei N = 128 und K = 3 gilt

$$|\Delta_{Mi}| \leq 2^{-15} Q/2$$

Das Ausgangssignal des Sigma-Delta-Modulators 1 ist gemäss Gleichung (1):

$$x_S[hT_S] = u_S[hT_S] + \Delta_{Su}[hT_S]$$

Im Verzögerungsglied 15 wird der vom Sigma-Delta Modulator 1 gelieferte 1-Bit-Strom $x_S[hT_S]$ mit den möglichen Werten {1, -1}, wie bereits erwähnt, um die Verzögerungsdauer D verzögert, um anschliessend im Digitalfilter 16, falls vorhanden, im schnellen Takt tiefpassgefiltert zu werden.

Die Verzögerung der Reihenschaltung 15;16 sollte möglichst gut der durch das Dezimationsfilter 12 verursachten Verzögerung angepasst sein. Eine möglichst kleine Verzögerung ist vom Implementationsaufwand her von Vorteil. Das Signal am Ausgang des Verzögerungsgliedes 15 ist:

$$d_S[hT_S] = x_S[(h-D)T_S]$$

Am Ausgang des Digitalfilters 16 steht das Signal $v_S[hT_S]$ in der schnellen Taktfrequenz $1/T_S$ und mit den möglichen Werten {+1, +1/2, 0, -1/2, -1} zur Verfügung. Es gilt

$$v_S[hT_S] = \bar{u}_S[hT_S] + \bar{\Delta}_{Su}[hT_S] \tag{14}$$

Die Reihenschaltung 15;16 des Verzögerungsgliedes 15 und des Digitalfilters 16 arbeitet immer im schnellen Takt $1/T_S$. Zu bemerken ist, dass das Digitalfilter 16 als sogenanntes "Sliding filter" arbeitet und keine Dezimation auf die langsamere mittelschnelle Taktfrequenz $1/T_M$ durchgeführt wird.

Für das Nutzsignal gilt in der Reihenschaltung 15;16 ähnliches wie im Falle des Dezimationsfilters 12. Es sind aber andere Verzerrungen vorhanden. Der zu erwartende Quantisierungsfehler ist nicht nur verschieden, sondern auch viel grösser, da nur eine bescheidene Filterung des Quantisierungsrauschens erfolgt

Wenn das Digitalfilter 16 z. B. ein "Sliding"-Sinc-Filter erster Ordnung der Länge vier ist, ist die Ausgangssequenz $v_S[hT_S]$ des Digitalfilters 16 sehr einfach, obwohl eine günstige Filterwirkung erzielt wird. Für die Übertragung gilt:

$$v_S[hT_S] = (1/4)\{d_S[hT_S] + d_S[(h-1)T_S] + d_S[(h-2)T_S] + d_S[(h-3)T_S]\} \tag{15}$$

Als Ausgangswerte der Sequenz $v_s[hT_s]$ kommen nur die 5 Werte {Q/2, Q/4, 0, -Q/4, -Q/2}, z. B. {+1, +1/2, 0, -1/2, -1} in Frage.

Für die linearisierte Übertragung des Quantisierungsfehlers $\bar{\Delta}_{Su}[hT_S]$ zum Ausgang des Digitalfilters 16 ergibt sich:

$$G_{\bar{\Delta}}(z) = z^{-D}G_4^1(z)G_{\Delta}(z) = (1/4)z^{-D}\left(\frac{1-z^{-4}}{1-z^{-1}}\right)(1-z^{-1})^2$$

$$= (1/4)\{z^{-D} - z^{-(D+1)} - z^{-(D+4)} + z^{-(D+5)}\} \qquad (17)$$

Daraus berechnet sich die Rauschleistung des Quantisierungsfehlers $\bar{\Delta}_{Su}[hT_s]$ am Ausgang des Digitalfilters 16 zu

$$\sigma_{\bar{\Delta}_{Su}}^2 = \frac{4}{16}\sigma_{\Delta Su}^2 = \frac{1}{4}\sigma_{\Delta Su}^2 = \frac{Q^2}{48} \qquad (18)$$

Für den Bitgewinn ergibt sich in diesem Fall

$$R_u = (1/2)\log_2\left(\frac{\sigma_{\Delta_{Su}}^2}{\sigma_{\bar{\Delta}_{Su}}^2}\right) = (1/2)\log_2 4 = 1 \qquad (19)$$

Die maximale Fehleramplitude bei angenommener Gleichverteilung reduziert sich somit nur um einen Faktor 2.

$$|\bar{\Delta}_{Su}| \leq 2^{-R_u}Q/2 = \frac{1}{2}Q/2 \qquad (20)$$

Das am Ausgang des Dezimationsfilters 12 erhaltene mittelschnelle Signal $y_M[kT_M]$ wird im Additionsglied 13 mit dem schnellen Signal $v_s[hT_s]$ der Taktfrequenz $1/T_S$ angesteuert. Da letzteres im gewählten Beispiel nur die Werte +1, +1/2, 0, -1/2 und -1 annehmen kann, müssen im Additionsglied 13 nur die Operationen "Verschieben", "Addiere/ Subtrahiere (+1/2,-1/2)" und "Addiere/Subtrahiere (+1, -1)" durchgeführt werden. Im Additionsglied 13 werden somit Verschiebungen und algebraische Additionen mit anschliessender Dezimation auf die langsame Taktfrequenz $1/T_M$ durchgeführt. Das Additionsglied 13 hat dabei die Aufgabe, das während N schnellen Takten der Frequenz $1/T_S$ konstante, vom Dezimationsfilter 12 herkommende Signal $y_M[kT_M]$ richtig anzusteuern. Anhand von zwei Beispielen soll der Vorgang erläutert werden.

a) Beispiel 1: Multiplikation von u[t] mit sich selber, d. h. $y_S[hT_S] = x_S[hT_S]$, mit N = 4, K =1, D = 4 und ohne Digitalfilter 16, d. h. mit $v_s[hT_S] = d_S[hT_S]$.

Unter Berücksichtigung der Gleichung (9a) für $y_M[kT_M]$ ergibt sich:

$$y_M[kT_M]=(1/4)\{y_s[kNT_s]+y_s[(kN-1)T_s]+y_s[(kN-2)T_s]+y_s[(kN-3)T_s]\}$$

$$v_s[hT_s]=y_s[(h-4)T_s]$$

Nach N Operationen wird das Ausgangssignal des Additionsgliedes 13 im Dividierglied 17 durch N geteilt, so dass am Ausgang des letzteren folgendes Signal $z_M[kT_M]$ ansteht:

$$z_M[kT_M] = (1/4) \cdot y_M[kT_M] \cdot \sum_{g=1}^{4} y_S[(kN+1-g)T_S]$$

$$= (1/4) \cdot y_M[kT_M] \cdot \{y_S[kNT_S] + y_S[(kN-1)T_S] + y_S[(kN-2)T_S] + y_S[(kN-3)T_S]\}$$

$$= (1/4)^2 \{y_S[kNT_S] + y_S[(kN-1)T_S] + y_S[(kN-2)T_S] + y_S[(kN-3)T_S]\}^2$$

$$= y_M^2[kT_M]$$

Dieses Resultat ist genau gleich dem Quadrat von $y_M[kT_M]$.

b) Beispiel 2: Multiplikation von u[t] mit sich selber, d. h. $y_S[hT_S] = x_S[hT_S]$, mit N = 4, K = 2, D = 4 und vorhandenem Digitalfilter 16, welches ein "Sliding"-Sinc-Filter erster Ordnung der Länge vier ist.

Unter Berücksichtigung der Gleichung (9b) für $y_M[kT_M]$ und der Gleichung (9a) für $v_S[hT_S]$ ergibt sich:

$$y_M[kT_M] = (1/4)^2 \{y_S[kNT_S] + 2y_S[(kN-1)T_S] + 3y_S[(kN-2)T_S] + 4y_S[(kN-3)T_S] +$$

$$3y_S[(kN-4)T_S] + 2y_S[(kN-5)T_S] + y_S[(kN-6)T_S]\}$$

$$d_S[hT_S] = y_S[(h-4)T_S]$$

$$v_S[hT_S] = (1/4)\{d_S[hT_S] + d_S[(h-1)T_S] + d_S[(h-2)T_S] + d_S[(h-3)T_S]\} =$$

$$(1/4)\{y_S[(h-4)T_S] + y_S[(h-5)T_S] + y_S[(h-6)T_S] + y_S[(h-7)T_S]\}$$

Nach N Operationen wird das Ausgangssignal des Additionsgliedes 13 wiederum im Dividierglied 17 durch N geteilt, so dass am Ausgang des letzteren folgendes Signal $z_M[kT_M]$ ansteht:

$$z_M[kT_M] = y_M[kT_M] \cdot (1/4) \sum_{g=1}^{4} v_S[(kN+g)T_S] = (1/4)^4 \{y_S[kNT_S] + 2y_S[(kN-1)T_S] + 3y_S[(kN-2)T_S] +$$

$$4y_S[(kN-3)T_S] + 3y_S[(kN-4)T_S] + 2y_S[(kN-5)T_S] + y_S[(kN-6)T_S]\} \cdot \sum_{g=1}^{4}\sum_{p=1}^{4} y_S[(kN+1-g-p)T_S] =$$

$$(1/4)^4 \{y_S[kNT_S] + 2y_S[(kN-1)T_S] + 3y_S[(kN-2)T_S] + 4y_S[(kN-3)T_S] + 3y_S[(kN-4)T_S] + 2y_S[(kN-5)T_S] + y_S[(kN-6)T_S]\}$$

$$\cdot \{y_S[kNT_S] + y_S[(kN-1)T_S] + y_S[(kN-2)T_S] + y_S[(kN-3)T_S]$$

$$+ y_S[(kN-1)T_S] + y_S[(kN-2)T_S] + y_S[(kN-3)T_S] + y_S[(kN-4)T_S]$$

$$+ y_S[(kN-2)T_S] + y_S[(kN-3)T_S] + y_S[(kN-4)T_S] + y_S[(kN-5)T_S]$$

$$+ y_S[(kN-3)T_S] + y_S[(kN-4)T_S] + y_S[(kN-5)T_S] + y_S[(kN-6)T_S]\} =$$

$$(1/4)^4 \{y_S[kNT_S] + 2y_S[(kN-1)T_S] + 3y_S[(kN-2)T_S] + 4y_S[(kN-3)T_S] + 3y_S[(kN-4)T_S] + 2y_S[(kN-5)T_S] + y_S[(kN-6)T_S]\}^2$$

Es ist ersichtlich, dass die Wirkung des Additionsgliedes 13 wiederum eine Quadrierung des Ausgangssignals $y_M[kT_M]$ des Dezimationsfilters 12 ist.

Das Ausgangssignal $z_M[kT_M]$ des Dividiergliedes 17 ist somit, wenn $y_S[hT_S] = x_S[hT_S]$, gleich dem Quadrat des Ausgangssignals $y_M[kT_M]$ des Dezimationsfilters 12 und damit auch, einmal vom herausgefilterten Störspektrum abgesehen, gleich dem Quadrat von dessen Eingangssignal $y_S[hT_S]$. Wenn $y_S[hT_S]$ und $x_S[hT_S]$ dagegen unterschiedlich sind, tritt anstelle des Quadrates von $y_S[hT_S]$ das Produkt $x_S[hT_S] \cdot y_S[hT_S]$, dessen Wert somit, wieder vom herausgefilterten Störspektrum abgesehen, als Signal $z_M[kT_M]$ am Ausgang des Dividiergliedes 17 erscheint. Bei kleiner Dynamik der Signale u[t] bzw. i[t] bzw. f[t] ist das

Ausgangssignal des Dividierglieses 17 allerdings relativ ungenau und muss durch eine Mittelung von $z_M[kT_M]$ im nachgeschalteten zweiten Dezimationsfilter 18 über mindestens eine Periode der Grundfrequenz des zeitfunktionalen Signals u[t] bzw. i[t] bzw. f[t] sowie eine nachfolgende Dezimation auf die langsame Taktfrequenz $1/T_L$ weiterverarbeitet werden, was am Ausgang des zweiten Dezimationsfilters 18 das Signal $z_L[jT_L]$ ergibt, welches dann gleich der Summe der am Ausgang des Dividiergliedes 17 während dieser Zeit erscheinenden Quadrate bzw. Produkte ist Im zweiten Dezimationsfilter 18 erfolgt somit z. B. eine Sinc-Filterung erster Ordnung mit nachfolgender Dezimation auf die langsame Taktfrequenz $1/T_L = 1/(W.T_M)$, sowie eine Division durch W. Die zeitfunktionalen Signale u[t] und i[t] sind z. B. proportional einer 50Hz-Netzspannung bzw. einem 50Hz-Netzstrom. Die Periode ihrer Grundfrequenz beträgt dann 20ms. Bei strenger Synchronisation sowie konventioneller direkter Multiplikation und Addition lässt sich die Genauigkeit der Multiplikation durch Mittelung über mehrere Perioden kaum verbessern. Im Falle der erfindungsgemässen Anordnung dagegen wird ein grösserer Mittelungseffekt erzielt, so dass Resultate erreicht werden können, die nahe bei denjenigen der konventionellen direkten Multiplikation und Addition liegen. Da sich das 1-Bit-Strom-Muster am Ausgang des Sigma-Delta-Modulators 1 bzw. 2 wegen den Anfangsbedingungen nicht ganz regelmässig wiederholt, werden auch die Fehlersequenzen am Ausgang der beiden Filter 12 und 16 sich nicht genau wiederholen.

Falls das Signal u[t] oder i[t] mit sich selber multipliziert wird, erscheint am Ausgang des Multiplizer/Addier-Gliedes 3 das Quadrat des Effektivwertes des betreffenden Signals u[t] bzw. i[t]. Falls nicht das Quadrat des Effektivwertes, sondern der Effektivwert selber ermittelt werden soll, ist der Ausgang des Multiplizier/Addier-Gliedes 3 mit einem Eingang eines Quadratwurzelziehungs-Gliedes 19 (Siehe Fig. 5) verbunden. Anschliessend an die Dezimierung auf die langsame Taktfrequenz $1/T_L$ im zweiten Dezimationsfilter 18 wird im Quadratwurzelziehungs-Glied 19 aus dem Ausgangssignal $z_L[jT_L]$ des zweiten Dezimationsfilters 18 durch Quadratwurzelziehen z. B. der Effektivwert $U_{eff}$ des zeitfunktionalen Signals u[t] ermittelt Das Quadratwurzelziehen im Quadratwurzelziehungs-Glied 19 erfolgt mit der langsamen Taktfrequenz $1/T_L$.

**Patentansprüche**

1. Anordnung zum Summieren von Produkten zweier zeitfunktionaler Signale (u[t], i[t] bzw. u[t], u[t] bzw. i[t], i[t] bzw. u[t], f[t] bzw. i[t], f[t]), wobei mindestens eines der Signale (u[t] bzw. i[t]) auf einen Signaleingang eines mit einer ersten Taktfrequenz $(1/T_S)$ betriebenen Sigma-Delta-Modulators (1 bzw. 2) geführt ist, dessen Ausgang mit mindestens einem von zwei Signaleingängen eines Multiplizier/Addier-Gliedes (3) verbunden ist, **dadurch gekennzeichnet, dass** innerhalb des Multiplizier/Addier-Gliedes (3) der eine Signaleingang über ein mit der ersten Taktfrequenz $(1/T_S)$ betriebenes erstes Dezimationsfilter (12) auf einen ersten Eingang eines, Additionsgliedes (13) geführt ist und der andere Signaleingang über eine mit der ersten Taktfrequenz $(1/T_S)$ betriebene Verzögerungsanordnung (14) auf einen zweiten Eingang des Additionsgliedes (13) geführt ist dass ein Ausgang des letzteren über ein Dividierglied (17) auf einen Signaleingang eines mit einer zweiten Taktfrequenz $(1/T_M)$ betriebenen zweiten Dezimationsfilters (18) geführt ist dessen Ausgang einen Ausgang des Multiplizier/Addier-Gliedes (3) bildet, und dass die zweite Taktfrequenz $(1/T_M)$ sowie eine dritte Taktfrequenz, $(1/T_L)$ dem Lesen eines Ausgangssignals des ersten beziehungsweise zweiten Dezimationsfilters (12 bzw. 18) dient, wobei die erste Taktfreguenz $(1/T_S)$ grösser als die zweite Taktfrequenz $(1/T_M)$ und die letztere grösser als die dritte Taktfrequenz $(1/T_L)$ ist.

2. Anordnung nach Anspruch 1, **dadurch gekennzeichnet, dass** die beiden Signale (u[t], i[t]) unterschiedliche zeitfunktionale Signale sind, die auf einen Signaleingang je eines zugehörigen, jeweils mit der ersten Taktfrequenz $(1/T_S)$ betriebenen Sigma-Delta-Modulators (1 bzw. 2) geführt sind, und dass die Ausgänge der beiden Sigma-Delta-Modulatoren (1, 2) mit je einem der beiden Signaleingänge des Multiplizier/Addier-Gliedes (3) verbunden sind.

3. Anordnung nach Anspruch 1, **dadurch gekennzeichnet, dass** die beiden Signale (u[t], u[t] bzw. i[t], i[t]) gleiche zeitfunktionale Signale sind, wovon eines auf den Signaleingang des Sigma-Delta-Modulators (1 bzw. 2) geführt ist, und dass der Ausgang des letzteren mit den beiden Signaleingängen des Multiplizier/Addier-Gliedes (3) verbunden ist.

4. Anordnung nach Anspruch 3, **dadurch gekennzeichnet, dass** ein Ausgang des Multiplizier/Addier-Gliedes (3) mit einem Eingang eines Quadratwurzelziehungs-Gliedes (19) verbunden ist.

5. Anordnung nach Anspruch 1, **dadurch gekennzeichnet, dass** ein erstes der beiden Signale (u[t], f[t] bzw. i[t], f[t]) ein im voraus nicht bekanntes zeitfunktionales Signal (u[t] bzw. i[t]) und das andere der beiden Signale (u[t], f[t] bzw. i[t], f[t]) eine bekannte zeitvariable Funktion (f[t]) ist, dass das erste Signal (u[t] bzw. i[t]) auf den Signaleingang des Sigma-Delta-Modulators (1 bzw. 2) geführt ist, dessen Ausgang mit dem einen der beiden Signaleingänge des Multiplizier/Addier-Gliedes (3) verbunden ist, und dass Einbit- oder Mehrbit-Digitalwerte der bekannten zeitvariablen Funktion (f[t]) auf den anderen der beiden Signaleingänge des Multiplizier/Addier-Gliedes (3) geführt sind, der als Bus-Eingang ausgebildet ist.

**6.** Anordnung nach einem der Ansprüche 1 bis 5, **dadurch gekennzeichnet, dass** jeder Sigma-Delta-Modulator (1 bzw. 2) ein Sigma-Delta-Modulator zweiter Ordnung ist.

**7.** Anordnung nach einem der Ansprüche 1 bis 6, **dadurch gekennzeichnet, dass** das erste Dezimationsfilter (12) ein Sinc-Filter der Ordnung K und einer Länge N ist, welche letztere gleich dem Verhältnis ($T_M/T_S$) der ersten zur zweiten Taktfrequenz ($1/T_S$ bzw. $1/T_M$) ist.

**8.** Anordnung nach einem der Ansprüche 1 bis 7, **dadurch gekennzeichnet, dass** der Teilungsfaktor des Dividiergliedes (17) gleich dem Verhältnis ($T_M/T_S$) der ersten zur zweiten Taktfrequenz ($1/T_S$ bzw.$1/T_M$) ist.

**9.** Anordnung nach einem der Ansprüche 1 bis 8, **dadurch gekennzeichnet, dass** das zweite Dezimationsfilter (18) ein Sinc-Filter erster Ordnung der Länge W ist, welche letztere gleich dem Verhältnis ($T_L/T_M$) der zweiten zur dritten Taktfrequenz ($1/T_M$ bzw. $1/T_L$) ist.

**10.** Anordnung nach einem der Ansprüche 1 bis 9, **dadurch gekennzeichnet, dass** die Verzögerungsanordnung (14) aus einem mit der ersten Taktfrequenz ($1/T_S$) betriebenen Verzögerungsglied (15) besteht.

**11.** Anordnung nach einem der Ansprüche 1 bis 10, **dadurch gekennzeichnet, dass** die Verzögerungsanordnung (14) aus einer Reihenschaltung (15;16) eines mit der ersten Taktfrequenz ($1/T_S$) betriebenen Verzögerungsgliedes (15) und eines nachgeschalteten, ebenfalls mit der ersten Taktfrequenz ($1/T_S$) betriebenen dezimationslosen Digitalfilters (16) besteht.

**12.** Anordnung nach Anspruch 11, **dadurch gekennzeichnet, dass** das dezimationslose Digitalfilter (16) ein Sinc-Filter erster Ordnung der Länge vier ist.

**13.** Anordnung nach einem der Ansprüche 10 bis 12, **dadurch gekennzeichnet, dass** die Verzögerungsdauer (D) des Verzögerungsgliedes (15) gleich K(N-1)/2 ist.

**Claims**

**1.** An arrangement for summing products of two time-functional signals (u[t], i[t] or u[t], u[t] or i[t], i[t] or u[t], f[t] or i[t], f[t]), wherein at least one of the signals (u[t] or i[t]) is passed to a signal input of a sigma-delta modulator (1 or 2) which is operated at a first clock rate ($1/T_S$) and whose output is connected to at least one of two signal inputs of a multiplier/adder member (3), **characterised in that** within the multiplier/adder member (3) the one signal input is passed by way of a first decimation filter (12) operated at the first clock rate ($1/T_S$) to a first input of an addition member (13) and the other signal input is passed by way of a delay arrangement (14) operated at the first clock rate ($1/T_S$) to a second input of the addition member (13), that an output of the latter is passed by way of a divider member (17) to a signal input of a second decimation filter (18) which is operated at a second clock rate ($1/T_M$) and whose output forms an output of the multiplier/adder member (3), and that the second clock rate ($1/T_M$) and a third clock rate ($1/T_L$) serves for reading of an output signal of the first and the second decimation filters (12 and 18) respectively, wherein the first clock rate ($1/T_S$) is greater than the second clock rate ($1/T_M$) and the latter is greater than the third clock rate ($1/T_L$).

**2.** An arrangement according to claim 1 **characterised in that** the two signals (u[t], i[t]) are different time-functional signals which are passed to a signal input of a respectively associated sigma-delta modulator (1 or 2) respectively operated at the first clock rate ($1/T_S$) and that the outputs of the two sigma-delta modulators (1, 2) are connected to a respective one of the two signal inputs of the multiplier/adder member (3).

**3.** An arrangement according to claim 1 **characterised in that** the two signals (u[t], u[t] or i[t], i[t]) are identical time-functional signals of which one is passed to the signal input of the sigma-delta modulator (1 or 2), and that the output of the latter is connected to the two signal inputs of the multiplier/adder member (3).

**4.** An arrangement according to claim 3 **characterised in that** an output of the multiplier/adder member (3) is connected to an input of a square root extraction member (19).

**5.** An arrangement according to claim 1 **characterised in that** a first of the two signals (u[t], f[t] or i[t], f[t]) is a time-functional signal (u[t] or i[t]) which is not known in advance and the other of the two signals (u[t], f[t] or i[t], f[t]) is a known time-variable function (f[t]), that the first signal (u[t] or i[t]) is passed to the signal input of the sigma-delta modulator (1 or 2) whose output is connected to the one of the two signal inputs of the multiplier/adder member (3), and that one-bit or multi-bit digital values of the known time-variable function (f[t]) are passed to the other of the two signal inputs of the multiplier/adder member (3) which is in the form of a bus input.

6. An arrangement according to one of claims 1 to 5 **characterised in that** each sigma-delta modulator (1 or 2) is a second-order sigma-delta modulator.

7. An arrangement according to one of claims 1 to 6 **characterised in that** the first decimation filter (12) is a sinc filter of the order K and a length N, which latter is equal to the ratio $(T_M/T_S)$ of the first to the second clock rate ($1/T_S$ and $1/T_M$ respectively).

8. An arrangement according to one of claims 1 to 7 **characterised in that** the division factor of the divider member (17) is equal to the ratio $(T_M/T_S)$ of the first to the second clock rate ($1/T_S$ and $1/T_M$ respectively).

9. An arrangement according to one of claims 1 to 8 **characterised in that** the second decimation filter (18) is a first-order sinc filter of the length W, which latter is equal to the ratio $(T_L/T_M)$ of the second to the third clock rate ($1/T_M$ and $1/T_L$ respectively).

10. An arrangement according to one of claims 1 to 9 **characterised in that** the delay arrangement (14) comprises a delay member (15) operated at the first clock rate ($1/T_S$).

11. An arrangement according to one of claims 1 to 10 **characterised in that** the delay arrangement (14) comprises a series circuit (15;16) of a delay member (15) operated at the first clock rate ($1/T_S$) and a downstream-connected decimation-less digital filter (16) which is also operated at the first clock rate ($1T/_s$).

12. An arrangement according to claim 11 **characterised in that** the decimation-less digital filter (16) is a first-order sinc filter of the length four.

13. An arrangement according to one of claims 10 to 12 **characterised in that** the delay duration (D) of the delay member (15) is equal to K(N-1)/2.

**Revendications**

1. Dispositif pour l'addition des produits de deux signaux fonction du temps (u [t], i [t] ou u [t],u [t] ou i [t], i [t] ou u [t], f [t] ou i [t], f [t], dans lequel au moins l'un des signaux (u [t] ou i [t]) est envoyé sur une entrée du signal d'un modulateur Sigma-Delta opérant à une première fréquence d'horloge ($1/T_S$) (1 ou 2), dont la sortie est reliée à au moins l'une de deux entrées du signal d'un organe multiplicateur/additionneur (3), **caractérisé par le fait qu'**à l'intérieur de l'organe multiplicateur/additionneur (3), la première entrée du signal est renvoyée, en passant par un premier filtre de décimalisation (12) opérant à la première fréquence d'horloge ($1/T_S$), à une première entrée d'un organe additionneur (13) et l'autre entrée du signal est renvoyée, en passant par un circuit à retard (14) opérant à la première fréquence d'horloge ($1/T_S$), à une seconde entrée de l'organe additionneur (13), qu'une sortie de ce dernier est renvoyée, en passant par un organe diviseur (17), à une entrée du signal d'un second filtre de décimalisation (18), opérant à une seconde fréquence d'horloge ($1/T_M$), dont la sortie forme une sortie de l'organe multiplicateur/additionneur (3), et que la seconde fréquence d'horloge ($1/T_M$) ainsi qu'une troisième fréquence d'horloge ($1/T_L$) servent à lire un signal de sortie du premier ou du second filtre de décimalisation (12 ou 18), la première fréquence d'horloge ($1/T_S$) étant supérieure à la seconde fréquence d'horloge ($1/T_M$) et cette dernière, supérieure à la troisième fréquence d'horloge ($1/T_L$).

2. Dispositif selon la revendication 1, **caractérisé par le fait que** les deux signaux (u [t], i [t]) sont des signaux différents, fonction du temps, qui sont respectivement envoyés à une entrée du signal d'un modulateur Sigma-Delta (1 ou 2) associé, opérant respectivement à la première fréquence d'horloge ($1/T_S$), et que les sorties des deux modulateur Sigma-Delta (1, 2) sont respectivement reliées à l'une des deux entrées du signal de l'organe multiplicateur/additionneur (3).

3. Dispositif selon la revendication 1, **caractérisé par le fait que** les deux signaux (u [t], u [t] ou i [t], i [t]) sont des signaux identiques, fonction du temps, dont l'un est envoyé à l'entrée du signal du modulateur Sigma-Delta (1 ou 2) et que la sortie de ce dernier est reliée au deux entrées du signal de l'organe multiplicateur/additionneur (3).

4. Dispositif selon la revendication 3, **caractérisé par le fait qu'**une sortie de l'organe multiplicateur/additionneur (3) est reliée à une entrée d'un organe d'extraction de la racine carrée (19).

5. Dispositif selon la revendication 1, **caractérisé par le fait qu'**un premier des deux signaux u [t], f [t] ou i [t], f [t]) est un signal fonction du temps, non connu à l'avance (u [t] ou i [t]) et que l'autre des deux signaux (u [t], f [t] ou i [t], f [t]) est une fonction connue, variable en fonction du temps (f [t]), que le premier signal (u [t] ou i [t]) est envoyé à l'entrée du signal du modulateur Sigma-Delta (1 ou 2) dont la sortie est reliée à l'une des deux entrées du signal de l'organe multiplicateur/additionneur (3) et que des valeurs numériques monobits ou multibits de la fonction connue variable en fonction du temps (f [t]) sont envoyées à l'autre des deux entrées du signal de l'organe multiplicateur/additionneur (3) qui est conçue sous forme d'entrée de bus.

6. Dispositif selon l'une des revendications 1 à 5, **caractérisé par le fait que** chaque modulateur Sigma-Delta (1 ou 2) est un modulateur Sigma-Delta du second ordre.

7. Dispositif selon l'une des revendications 1 à 6, **caractérisé par le fait que** le premier filtre de décimalisation (12) est un filtre de synchronisation d'ordre K et de longueur N, cette dernière étant égale au rapport $(T_M/T_S)$ de la première à la seconde fréquence d'horloge $(1/T_S$ et $1/T_M)$.

8. Dispositif selon l'une des revendications 1 à 7, **caractérisé par le fait que** le facteur de division de l'organe diviseur (17) est égal au rapport $(T_M/T_S)$ de la première à la seconde fréquence d'horloge $(1/T_S$ et $1/T_M)$.

9. Dispositif selon l'une des revendications 1 à 7, **caractérisé par le fait que** le second filtre de décimalisation (18) est un filtre de synchronisation du premier ordre de longueur W cette dernière étant égale au rapport $(T_L/T_M)$ de la seconde à la troisième fréquence d'horloge $(1/T_M$ et $1/T_L)$.

10. Dispositif selon l'une des revendications 1 à 9, **caractérisé par le fait que le fait que** le circuit à retard (14) est constitué d'un organe de retard (15) opérant à la première fréquence d'horloge $(1/T_S)$.

11. Dispositif selon l'une des revendications 1 à 10, **caractérisé par le fait que** le circuit à retard (14) est constitué d'un circuit de série (15 ; 16) d'un organe de retard (15) opérant à la première fréquence d'horloge $(1/T_S)$ et d'un filtre numérique sans décimalisation (16) opérant également à la première fréquence d'horloge $(1/T_S)$, mis en circuit à la suite.

12. Dispositif selon la revendication 11, **caractérisé par le fait que** le filtre numérique sans décimalisation (16) est un filtre de synchronisation du premier ordre de longueur quatre.

13. Dispositif selon l'une des revendications 10 à 12, **caractérisé par le fait que** la durée du retard (D) de l'organe de retard (15) est égale à K (N-1)/2.

Fig. 1

Fig. 2

Fig. 3

# Fig. 4

Fig. 5